# FASCICULE DE BREVET EUROPEEN

(11) **EP 1 499 018 B1**
(45) Date de publication et mention de la délivrance du brevet: **07.10.2009**
(21) Numéro de dépôt: 04354025.1
(22) Date de dépôt: 29.06.2004
(51) Int. Cl.: H03H 3/04

(54) **Résonateur acoustique de volume à fréquence de résonance ajustée et procédé de réalisation**
Volumenwellenresonator mit angepasster Resonanzfrequenz und Herstellungsverfahren hierfür
Bulk acoustic wave resonator with adjusted resonance frequency and its fabrication method

(30) Priorité: 17.07.2003 FR 0308715
(43) Date de publication de la demande: 19.01.2005
(73) Titulaire: COMMISSARIAT A L'ENERGIE ATOMIQUE, 75752 Paris Cédex 15 (FR); STMicroelectronics S.A., 92120 Montrouge (FR)
(72) Inventeur: Robert, Philippe, 38100 Grenoble (FR); Ancey, Pascal, 38420 Revel (FR); Caruyer, Grégory, 38570 Goncelin (FR)
(74) Mandataire: Jouvray, Marie-Andrée

(56) Documents cités:
- WO-A-84/00082
- GB-A- 264 878
- GB-A- 971 571
- US-A- 5 587 620
- US-B1- 6 339 276
- PATENT ABSTRACTS OF JAPAN vol. 012, no. 412 (E-676), 31 octobre 1988 (1988-10-31) & JP 63 151103 A (NIPPON DEMPA KOGYO CO LTD), 23 juin 1988 (1988-06-23)

## Description

### Domaine technique de l'invention

L'invention concerne un résonateur acoustique de volume ayant au moins une fréquence de résonance et comportant une couche piézoélectrique disposée entre deux électrodes.

### État de la technique

Dans une chaîne d'émission-réception, par exemple pour communication mobile, plusieurs niveaux de filtrage radiofréquence sont nécessaires : en sortie d'antenne, comme filtre de rejet, etc... Pour réaliser des filtres radiofréquence, actuellement, trois techniques principales sont utilisées :
- Les circuits du type RLC, qui sont intégrables, mais dont les caractéristiques sont médiocres compte tenu des performances de chacun des composants, en particulier de l'inductance, le facteur de qualité d'une inductance intégrée dépassant difficilement 30.
- Les filtres céramiques, qui ne sont pas intégrables.
- Les composants à ondes acoustiques de surface (« SAW : surface acoustic wave »), qui ne sont pas intégrables.

Dans les composants de type SAW, une onde acoustique de surface est excitée dans un matériau piézoélectrique par un premier réseau d'électrodes en peigne. Un deuxième réseau d'électrodes en peigne est intercalé dans le premier réseau et détecte l'onde de surface pour fournir la tension de sortie du filtre. La largeur, l'écartement et le nombre de doigts des peignes déterminent une fréquence de résonance ou une bande passante du filtre. La surface de ces composants, typiquement de plusieurs mm², et les matériaux utilisés les rendent inadaptés à une intégration sur circuits intégrés. Par ailleurs, les filtres du type SAW sont limités en fréquence à une gamme comprise entre 100MHz et environ 2,5 GHz.

Un autre axe de recherche apparaît, basé sur l'utilisation de résonateurs à ondes acoustiques de volume (« BAW : bulk acoustic wave »). Ces résonateurs peuvent être intégrés et offrent des facteurs de qualité importants (>1000). Une onde acoustique de volume est excitée dans une couche mince piézoélectrique comprise entre deux électrodes. Des filtres réalisés à partir de résonateurs de type BAW comportent généralement plusieurs résonateurs couplés. Les fréquences de résonance des résonateurs individuels déterminent la fréquence centrale du filtre. Sa bande passante dépend des caractéristiques du couplage, par exemple de la position et de la rigidité, tandis que le nombre de résonateurs donne l'ordre du filtre. Ce type de résonateur permet de réaliser des filtres dans une gamme comprise entre 300 MHz et environ 10 GHz.

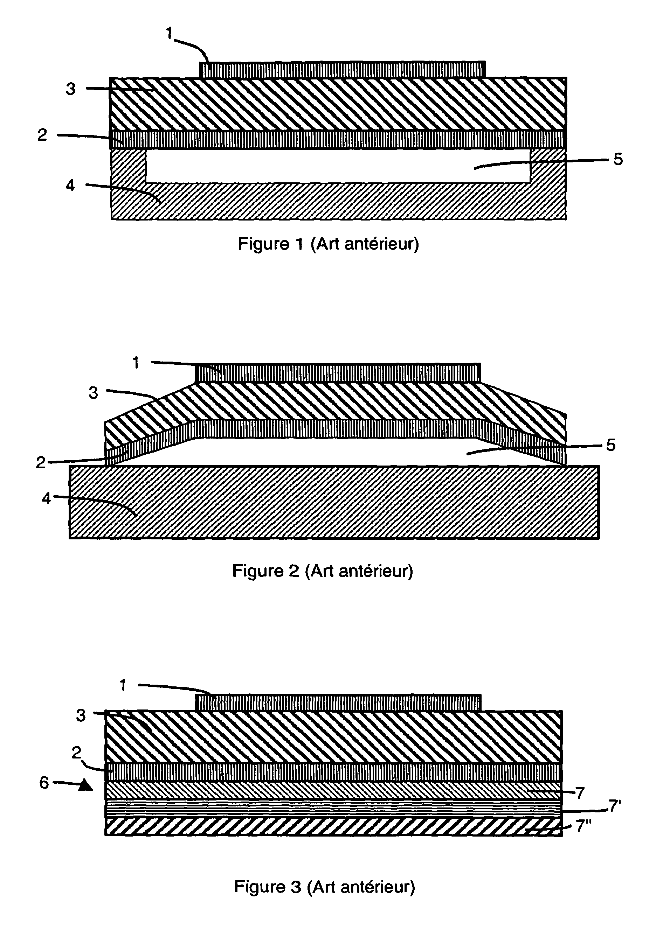

On distingue deux types de résonateurs acoustiques de volume :
- Les résonateurs acoustiques de volume à couche mince (« FBAR : Thin Film Bulk Acoustic Resonators »), représentés aux figures 1 et 2, où l'empilement constitué par les deux électrodes 1 et 2 et la couche piézoélectrique 3, est éloigné d'un substrat 4 par une cavité 5 permettant de réduire la dissipation des ondes acoustiques. La cavité 5 est réalisée soit par gravure du substrat 4 (figure 1) soit en suspendant ledit empilement (figure 2) par l'utilisation d'une couche sacrificielle lors de la fabrication.
- Les résonateurs montés solidement (« SMR : Solidly Mounted Resonators » ), dans lesquels l'empilement constitué par les deux électrodes 1 et 2 et la couche piézoélectrique 3 est disposé sur un réseau de Bragg 6 acoustique destiné à réfléchir l'onde acoustique (figure 3). Un réseau de Bragg acoustique est constitué d'un empilement de couches, 7, 7' et 7" sur la figure 3, de matériaux différents présentant des impédances acoustiques très différentes, l'épaisseur de chaque couche 7, 7' et 7" correspondant approximativement à un quart de la longueur d'onde acoustique.

Pour ces deux types de résonateurs acoustiques de volume, la fréquence de résonance est inversement proportionnelle à l'épaisseur de la couche piézoélectrique 3. Dans le cas d'une couche piézoélectrique en nitrure d'aluminium, par exemple, une fréquence de 2GHz est obtenue pour une épaisseur de 1,8 µm environ.

Dans les applications radiofréquence, on recherche classiquement des fréquences de résonance de l'ordre du GHz, qui correspondent à des épaisseurs de couches piézoélectriques voisines du micron. Un contrôle de la fréquence à une dizaine de MHz près correspond à un contrôle de l'épaisseur de la couche piézoélectrique de l'ordre de 10 nm, c'est-à-dire d'environ 1% de l'épaisseur totale, ce qui d'un point de vue industriel n'est guère envisageable. Les erreurs d'épaisseur des électrodes et de la couche piézoélectrique induisent alors une erreur de la fréquence de résonance. Par conséquent, on utilise des méthodes d'ajustement de la fréquence de résonance, en cours ou après réalisation du composant. Or, les méthodes d'ajustement connues détériorent les performances du composant final et/ou rendent sa fabrication compliquée. En effet, pour modifier la fréquence de résonance après fabrication du composant, il est possible de lui associer une diode du type varactor (« variable capacitor ») en série. Le changement de la valeur de la capacité variable de la diode modifie la fréquence de résonance de l'ensemble. Cependant, le facteur de qualité des diodes du type varactor est très faible par rapport aux facteurs de qualité des résonateurs du type BAW et réduit, ainsi, considérablement le facteur de qualité de l'ensemble.

D'autres méthodes d'ajustement de la fréquence de résonance reposent sur des dépôts ou des gravures successives et des mesures de fréquence de résonance intermédiaires. Ces méthodes sont généralement lourdes et coûteuses.

Dans le document US 5,873,153, un matériau conducteur fusible est disposé dans la cavité d'un résonateur de type FBAR. Le passage d'un courant provoque l'évaporation du matériau fusible, qui se dépose sur les parois de la cavité. Dans une première approche, le matériau fusible est initialement disposé sur le substrat et se dépose, après évaporation, en formant une couche sur l'électrode disposée sur la cavité. Cette méthode nécessite, en plus des étapes classiques de fabrication du résonateur, de venir positionner et aligner une plaque comportant le matériau fusible sous chaque composant. Le matériau évaporé peut générer des contraintes et dégrader les performances du résonateur. De plus, la couche de matériau évaporé peut modifier les propriétés acoustiques par ajout d'une interface. Dans une seconde approche, le matériau fusible est initialement disposé sous forme d'une couche sur l'électrode et se dépose, après évaporation, sur les parois de la cavité appartenant au substrat. Le matériau fusible non-évaporé peut modifier les propriétés acoustiques par ajout de l'interface entre ce matériau et l'électrode. Les deux approches conviennent aux résonateurs du type FBAR, mais ne sont pas applicables aux résonateurs du type SMR. De plus, l'ajustement de fréquence se fait par l'intermédiaire d'une couche supplémentaire sur l'électrode dans laquelle la densité d'énergie acoustique est assez faible. L'effet d'une modification de cette couche supplémentaire est, par conséquent, faible par rapport à l'influence de l'épaisseur de la couche piézoélectrique ou des électrodes.

### Objet de l'invention

L'invention a pour but de remédier à ces inconvénients et, en particulier, de réaliser un résonateur acoustique de volume ayant une fréquence de résonance prédéterminée, tout en simplifiant le procédé de fabrication.

Selon l'invention, ce but est atteint par les revendications annexées et, plus particulièrement, par le fait que le résonateur comporte des moyens de chauffage disposés en contact thermique avec au moins une des électrodes et permettant, par chauffage temporaire de l'électrode, d'évaporer partiellement le matériau constituant l'électrode.

L'invention a également pour but un procédé comportant
- le dépôt d'une première électrode sur un substrat,
- le dépôt de la couche piézoélectrique sur la première électrode,
- le dépôt d'une deuxième électrode sur la couche piézoélectrique,
- la réalisation des moyens de chauffage, disposés en contact thermique avec au moins une des électrodes,
- la commande, pendant une période déterminée, des moyens de chauffage, de manière à amincir l'électrode, par évaporation du matériau la constituant et, ainsi, à ajuster la fréquence de résonance.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 à 3 représentent des résonateurs acoustiques de volume selon l'art antérieur.
Les figures 4 et 5 représentent un mode de réalisation particulier d'un résonateur du type FBAR selon l'invention, respectivement en coupe et en vue de dessus.
Les figures 6 et 7 représentent un mode de réalisation particulier d'un résonateur du type SMR selon l'invention, respectivement en coupe et en vue de dessus.

### Description de modes particuliers de réalisation

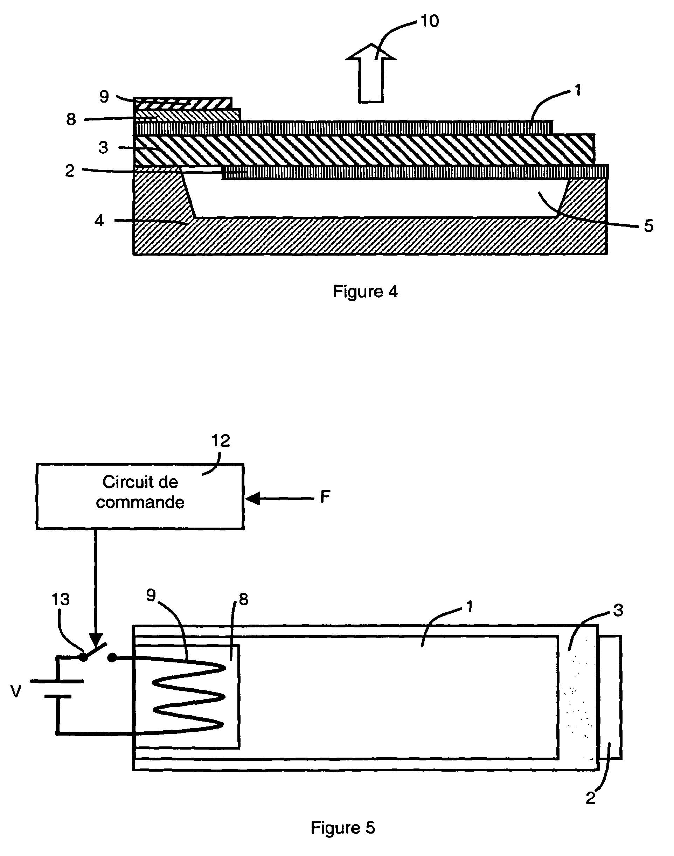

Le résonateur acoustique de volume représenté aux figures 4 et 5 comporte une couche piézoélectrique 3 disposée entre deux électrodes 1 et 2 planes. L'ensemble de la couche piézoélectrique 3 et des deux électrodes 1 et 2 est disposé sur un substrat 4 comportant une cavité 5 sur laquelle est disposée l'une des électrodes 2. Sur la face extérieure de l'autre électrode 1, est disposée une couche électriquement isolante 8. Une résistance électrique 9 de chauffage de l'ordre de quelques centaines d'ohms, est disposée sur la couche isolante 8. La couche isolante 8 est suffisamment fine pour permettre un contact thermique entre l'électrode 1 et la résistance électrique 9. Un circuit de contrôle 12 d'un interrupteur 13, disposé en série avec la résistance, permet d'appliquer temporairement une tension électrique V aux bornes de la résistance électrique 9 (figure 5). L'électrode 1 correspondante est ainsi chauffée, ce qui provoque l'évaporation partielle (schématisée par la flèche 10) du matériau constituant l'électrode 1 (figure 4) et, ainsi, l'amincissement de l'électrode 1. L'électrode 2 s'amincit également, dans une plus faible proportion que l'électrode 1, par conduction thermique via la couche piézoélectrique 3.

La fréquence de résonance F du résonateur acoustique de volume dépendant de l'épaisseur des électrodes 1 et 2, l'amincissement correspond à une modification de la fréquence de résonance. Ainsi, la fréquence de résonance F peut être ajustée de manière contrôlée en évaporant progressivement une partie du matériau constituant l'électrode 1 et/ou l'électrode 2. Dans un mode de réalisation préférentiel, la fréquence de résonance F, mesurée par tout moyen approprié commun, est fournie au circuit de contrôle 12 et la commande de la résistance électrique 9 de chauffage est interrompue (ouverture de l'interrupteur 13) lorsque la fréquence de résonance désirée est obtenue.

L'épaisseur initiale de l'électrode à amincir est suffisamment importante, par exemple environ 0,2 µm, pour permettre de compenser une erreur de fréquence de résonance correspondant aux variations d'épaisseur des électrodes et de la couche piézoélectrique dues à la fabrication.

Dans le cas d'un résonateur du type FBAR, l'électrode disposée sur la cavité peut également être amincie, au moyens d'une résistance de chauffage correspondante, à moins que le résonateur ne comporte une membrane diélectrique disposée entre le substrat et l'électrode correspondante.

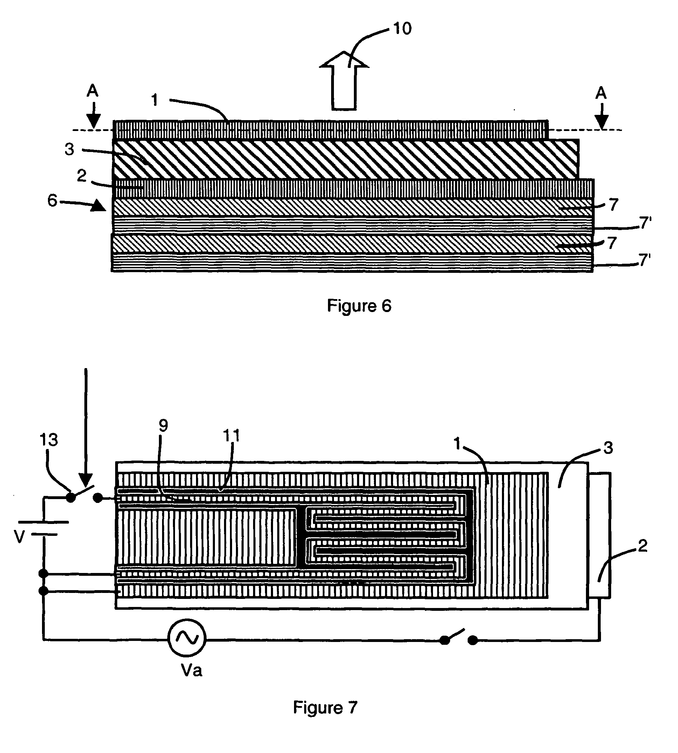

Aux figures 6 et 7, la face extérieure d'une première électrode 2 est disposée sur un substrat constitué par un réseau de Bragg 6 acoustique. Le réseau de Bragg 6 est composé d'un empilement de couches, alternativement 7 et 7', de matériaux présentant des impédances acoustiques très différentes. La première électrode 2 étant enfermée entre le réseau de Bragg 6 et la couche piézoélectrique 3, elle ne peut être évaporée. Ainsi, dans un résonateur de ce type, la résistance électrique 9 de chauffage peut uniquement être disposée en contact thermique avec la deuxième électrode 1.

Dans le mode particulier de réalisation représenté sur les figures 6 et 7, la résistance électrique 9 de chauffage est intégrée dans la deuxième électrode 1. Comme représenté à la figure 7, une couche électriquement isolante 11 est intégrée dans la deuxième électrode 1, de manière à délimiter la résistance électrique 9 de chauffage dans le matériau de l'électrode 1. Comme représenté sur la figure 7, pendant la génération d'ondes acoustiques dans le résonateur, une borne d'une source de tension alternative Va, appliquée entre les première et deuxième électrodes (2 et 1), peut également être connectée à la résistance électrique 9 de chauffage, qui constitue, ainsi, une partie de l'électrode 1.

La résistance électrique 9 de chauffage forme, de préférence, un serpentin. Le serpentin est dimensionné (longueur, largeur, nombre de méandres) en fonction de la résistivité du matériau utilisé et de son épaisseur, de manière à obtenir une résistance chauffante de quelques centaines d'ohms. Le serpentin peut éventuellement couvrir entièrement la surface de l'électrode 1. Dans ce cas, la résistance électrique 9 constitue elle-même l'électrode 1.

Selon un mode particulier de réalisation d'un procédé de fabrication d'un résonateur, une première électrode 2 est déposée sur un substrat, par exemple sur un substrat constitué par un réseau de Bragg 6 acoustique, comme représenté sur la figure 6, ou sur un substrat 4 comportant une cavité 5 (figure 4) remplie d'une couche sacrificielle. Puis la couche piézoélectrique 3 est déposée sur la première électrode 2 et la deuxième électrode 1 est ensuite déposée sur la couche piézoélectrique 3 (figures 4 et 6). Les matériaux typiquement utilisés sont le nitrure d'aluminium ou l'oxyde de zinc pour la couche piézoélectrique 3 et l'aluminium, le molybdène ou le platine pour les électrodes 1 et 2. La profondeur d'une cavité 5 dans la face avant du substrat 4 est typiquement de l'ordre de 0,5 µm. L'épaisseur des électrodes 1 et 2 est environ de 0,2 µm. Ensuite, la résistance électrique 9 de chauffage est réalisée, par exemple par gravure d'une rainure en forme de serpentin dans la deuxième électrode 1 et par dépôt de la couche électriquement isolante 11 (figure 7) dans cette rainure. Afin d'évaporer partiellement le matériau de la deuxième électrode 1, une tension électrique V, de l'ordre de 5V, est appliquée temporairement à la résistance électrique 9. Ainsi, l'électrode 1 est amincie par évaporation 10 (figure 6) du matériau la constituant, de préférence sous vide, ce qui permet d'ajuster la fréquence de résonance F.

Comme précédemment, la fréquence de résonance F peut être mesurée au cours de l'évaporation 10 du matériau de l'électrode 1, de manière à provoquer l'interruption de la commande de la résistance électrique 9 de chauffage lorsque la fréquence de résonance désirée est obtenue.

L'invention est applicable aussi bien aux résonateurs de type FBAR qu'aux résonateurs de type SMR et elle n'est pas limitée aux modes de réalisation représentés. En particulier, plusieurs résistances électriques de chauffage peuvent être utilisées.

La réalisation du résonateur est compatible avec les technologies de fabrication des circuits intégrés. L'ajustement de la fréquence peut être automatisé par un circuit de commande intégré, avec le résonateur, sur une même puce.

## Revendications

1. Résonateur acoustique de volume ayant au moins une fréquence de résonance, comportant une couche piézoélectrique (3) disposée entre deux électrodes (1, 2), résonateur **caractérisé en ce qu'**il comporte des moyens de chauffage disposés en contact thermique avec au moins une des électrodes (1) et permettant, par chauffage temporaire de l'électrode (1), d'évaporer partiellement le matériau constituant l'électrode (1).

2. Résonateur selon la revendication 1, **caractérisé en ce que** les moyens de chauffage comportent au moins une résistance électrique (9).

3. Résonateur selon la revendication 2, **caractérisé en ce qu'**il comporte une couche électriquement isolante (8) sur une face extérieure d'au moins une des électrodes (1), la résistance électrique (9) étant disposée sur la face extérieure de la couche électriquement isolante (8).

4. Résonateur selon la revendication 2, **caractérisé en ce que** la résistance électrique (9) est intégrée dans l'électrode (1).

5. Résonateur selon l'une quelconque des revendications 1 à 4, **caractérisé en ce que** la face extérieure d'une des électrodes (2) est disposée sur un substrat constitué par un réseau de Bragg acoustique (6), les moyens de chauffage étant en contact thermique avec l'autre électrode (1).

6. Résonateur selon l'une quelconque des revendications 1 à 4, **caractérisé en ce qu'**il comporte un substrat (4) comportant une cavité (5) sur laquelle est disposée, au moins partiellement, l'une des électrodes (2).

7. Procédé de fabrication d'un résonateur acoustique de volume selon l'une quelconque des revendications 1 à 6, **caractérisé en ce qu'**il comporte
- le dépôt d'une première électrode (2) sur un substrat (4),
- le dépôt de la couche piézoélectrique (3) sur la première électrode (2),
- le dépôt d'une deuxième électrode (1) sur la couche piézoélectrique (3),
- la réalisation des moyens de chauffage (9), disposés en contact thermique avec au moins une des électrodes (1),
- la commande (12, 13), pendant une période déterminée, des moyens de chauffage, de manière à amincir l'électrode (1), par évaporation (10) du matériau la constituant et, ainsi, à ajuster la fréquence de résonance (F).

8. Procédé selon la revendication 7, **caractérisé en ce qu'**il comporte la mesure de la fréquence de résonance (F) au cours de l'évaporation (10) du matériau de l'électrode (1), et l'interruption de la commande (12, 13) des moyens de chauffage lorsque la fréquence de résonance désirée est obtenue.

## Claims

1. Bulk acoustic resonator having at least one resonance frequency, comprising a piezoelectric layer (3) arranged between two electrodes (1, 2), resonator **characterized in that** it comprises heating means arranged in thermal contact with at least one of the electrodes (1) and enabling the material constituting the electrode (1) to be partially evaporated by temporary heating of the electrode (1).

2. Resonator according to claim 1, **characterized in that** the heating means comprise at least one electrical resistor (9).

3. Resonator according to claim 2, **characterized in that** it comprises an electrically insulating layer (8) on an external face of at least one of the electrodes (1), the electrical resistor (9) being arranged on the external face of the electrically insulating layer (8).

4. Resonator according to claim 2, **characterized in that** the electrical resistor (9) is integrated in the electrode (1).

5. Resonator according to anyone of claims 1 to 4, **characterized in that** the external face of one of the electrodes (2) is arranged on a substrate formed by an acoustic Bragg grating (6), the heating means being in thermal contact with the other electrode (1).

6. Resonator according to anyone of claims 1 to 4, **characterized in that** it comprises a substrate (4) comprising a cavity (5) whereon one of the electrodes (2) is at least partially arranged.

7. Fabrication process of a bulk acoustic resonator according to anyone of claims 1 to 6, **characterized in that** it comprises
- deposition of a first electrode (2) on a substrate (4),
- deposition of the piezoelectric layer (3) on the first electrode (3),
- deposition of a second electrode (1) on the piezoelectric layer (3),
- achievement of the heating means (9), arranged in thermal contact with at least one of the electrodes (1),
- operation (12, 13) of the heating means during a set period so as to thin the electrode (1) by evaporation (10) of the material constituting the latter, and thus to adjust the resonance frequency (F).

8. Process according to claim 7, **characterized in that** it comprises measurement of the resonance frequency (F) in the course of evaporation (10) of the material of the electrode (1), and interruption of operation (12, 13) of the heating means when the required resonance frequency is obtained.

## Patentansprüche

1. Akustische-Volumenwellen-Resonator mit mindestens einer Resonanzfrequenz, der eine piezoelektrische Schicht (3) hat, die zwischen zwei Elektroden (1, 2) angeordnet ist, Resonator, der **dadurch gekennzeichnet ist, dass** er Heizmittel umfasst, die thermischen Kontakt mit mindestens einer der Elektroden (1) haben und durch vorübergehendes Erhitzen der Elektrode (1) eine Verdampfung des Materials erlaubt, aus dem die Elektrode (1) besteht.

2. Resonator nach Anspruch 1, **dadurch gekennzeichnet, dass** die Heizmittel mindestens einen elektrischen Widerstand (9) umfassen.

3. Resonator nach Anspruch 2, **dadurch gekennzeichnet, dass** er an einer Außenseite mindestens einer der Elektroden (1) eine elektrisch isolierende Schicht (8) umfasst, wobei der elektrische Widerstand (9) an der Außenseite der elektrisch isolierenden Schicht (8) angeordnet ist.

4. Resonator nach Anspruch 2, **dadurch gekennzeichnet, dass** der elektrische Widerstand (9) in die Elektrode (1) eingebaut ist.

5. Resonator nach einem der Ansprüche 1 bis 4, **dadurch gekennzeichnet, dass** die Außenseite einer der Elektroden (2) auf einem Substrat angeordnet ist, das aus einem akustischen Bragg-Gitter (6) besteht, wobei die Heizmittel thermischen Kontakt mit der anderen Elektrode (1) haben.

6. Resonator nach einem der Ansprüche 1 bis 4, **dadurch gekennzeichnet, dass** er ein Substrat (4) umfasst, das eine Aufnahme (5) umfasst, auf der eine der Elektroden (2) zumindest teilweise angeordnet ist.

7. Verfahren zur Herstellung eines Akustische-Volumenwellen-Resonators nach einem der Ansprüche 1 bis 6, **dadurch gekennzeichnet, dass** es umfasst:
- das Aufbringen einer ersten Elektrode (2) auf ein Substrat (4),
- das Aufbringen der piezoelektrischen Schicht (3) auf die erste Elektrode (2),
- das Aufbringen einer zweiten Elektrode (1) auf die piezoelektrische Schicht (3),
- Anordnung von Heizmitteln (9), die in thermischem Kontakt mit mindestens einer der Elektroden (1) sind,
- Steuerung (12, 13) der Heizmittel während eines bestimmten Zeitraums, um die Elektrode (1) durch Verdampfung (10) des Materials, aus dem sie besteht, dünner zu machen und so die Resonanzfrequenz (F) anzupassen.

8. Verfahren nach Anspruch 7, **dadurch gekennzeichnet, dass** es die Messung der Resonanzfrequenz (F) während der Verdampfung (10) des Elektrodenmaterials (1) sowie die Unterbrechung der Steuerung (12, 13) der Heizmittel umfasst, wenn die gewünschte Resonanzfrequenz erreicht ist.
